# EUROPEAN PATENT APPLICATION

(11) **EP 2 291 068 A2**
(43) Date of publication of application: **02.03.2011**
(21) Application number: 10008787.3
(22) Date of filing: 24.08.2010
(51) Int. Cl.: H05K 13/08

(54) **A method and system of managing board assembling line**

(30) Priority: 24.08.2009 JP 2009193718; 24.08.2009 JP 2009193719
(71) Applicant: Hitachi High-Tech Instruments Company, Ltd., Kumagaya-shi Saitama 360-0238 (JP)
(72) Inventor: Wada, Toshiaki, Ora-gun, Gunma (JP); Iida, Shigeru, Ota-shi, Gunma (JP); Hirano, Katsumi, Gyoda-shi, Saitama (JP); Nitta, Hiroaki, Gyoda-shi, Saitama (JP); Katsuta, Shigeo, Ora-gun, Gunma (JP)
(74) Representative: Glawe, Delfs, Moll

(57) **Abstract**

Even when there is a plurality of work apparatuses in a board assembling line, the invention decreases manager's work by enabling the manager to operate any one of the work apparatuses to start the mounting operations of the other work apparatuses, when a microcomputer (2) of an electronic component mounting apparatus (1) that is the third from the left transmits a start command to the other electronic component mounting apparatuses (1), the microcomputer (2) of the electronic component mounting apparatus (1) that receives the start command turns on the tower light and turns on and sounds the buzzer thereof for three seconds if it judges itself as startable. By this, the electronic component mounting apparatus (1) that receives the start command informs the manager that the electronic component mounting apparatus (1) that receives the start command is to start the mounting operation, and the manager recognizes this. The electronic component mounting apparatus (1) that receives the start command then starts the mounting operation or makes a printed board ready.

## Description

### Field of the Invention:

The invention relates to a method of managing a board assembling line in which a printed circuit board is assembled by mounting electronic components thereon. In detail, the invention relates to a method of managing a board assembling line including a screen printing apparatus that coats solder paste on a printed board or an electronic component mounting apparatus that picks up an electronic component from a component feeding device by a suction nozzle and mounts this electronic component on a printed board.

An electronic component mounting apparatus of this type is disclosed in the Japanese Patent Application Publication No. 2005-159209 and so on, for example. Work apparatuses such as screen printing apparatuses or electronic component mounting apparatuses that form a board assembling line are respectively operated so as to start the mounting operations thereof.

Furthermore, work apparatuses such as screen printing apparatuses or electronic component mounting apparatuses that form a board assembling line are respectively operated so as to discharge printed boards toward the downstream work apparatuses next to these apparatuses and then stop the mounting operations thereof respectively.

However, when there is a plurality of electronic components mounting apparatuses in a board assembling line, it is very troublesome for a manager to operate each of the electronic component mounting apparatuses so as to start the mounting operations thereof since the manager need walk around the electronic component mounting apparatuses so as to start the mounting operations.

Furthermore, when there are screen printing apparatuses or electronic component mounting apparatuses in a board assembling line, it is very troublesome for a manager to operate each of the screen printing apparatuses or the electronic component mounting apparatuses so as Lo start the printing operations or the mounting operations thereof since the manager need walk around the screen printing apparatuses or the electronic component mounting apparatuses so as to start the printing operations or the mounting operations.

Furthermore, it is very troublesome for a manager to operate each of the screen printing apparatuses or the electronic component mounting apparatuses so as to discharge printed boards toward the downstream work apparatuses next to these apparatuses respectively since the manager need walk around the work apparatuses so as to discharge printed boards and then stop the mounting operations.

It is an object of the invention to lessen these drawbacks.

### SUMMARY OF THE INVENTION

The solution according to the invention resides in the features of the independent claims and preferably in those of the dependent claims.

Even when there is a plurality of work apparatuses in a board assembling line, the invention decreases manager's work by enabling the manager to operate any one of the work apparatuses so as to start the mounting operations or printing operations of the other work apparatuses and by enabling the manager to operate any one of the work apparatuses so as to discharge printed boards from the other work apparatuses respectively.

The invention provides a method of managing a board assembling line including a plurality of work apparatuses, wherein a printed circuit board is assembled by mounting electronic components thereon using the work apparatuses, the method including: transmitting a work start command to start a work from any one of the plurality of work apparatuses to the other work apparatus.

In the method, the work includes mounting the electronic components on the printed board.

In the method, the work includes discharging the printed board from an upstream work apparatus to a downstream work apparatus among the plurality of work apparatuses.

The invention further relates to a corresponding system for managing board assembling line.

### BRIEF DESCRIPTION OF THE DRAWINGS

Fig. 1 is a schematic view of a board assembling line.
Fig. 2 is a table showing line registered apparatus list data.
Fig. 3 is a flowchart for an electronic component mounting apparatus on a transmitter side.
Fig. 4 is a flowchart for an electronic component mounting apparatus on a receiver side.
Fig. 5 shows a response format.
Fig. 6 shows a line start error screen.
Fig. 7 shows a screen when a local is selected.
Fig. 8 shows a screen when a line is selected.
Fig. 9 is a flowchart for an electronic component mounting apparatus on a transmitter side.
Fig. 10 is a flowchart for an electronic component mounting apparatus on a receiver side.
Fig. 11 is a flowchart for the discharge of a last printed board in each of the electronic component mounting apparatuses.
Fig. 12 is a flowchart when a line discharge execution command is received.
Fig. 13 shows a screen when a local is selected.
Fig. 14 shows a screen when a line is selected.

### DETAILED DESCRIPTION OF THE INVENTION

A first embodiment of the invention will be described hereafter.

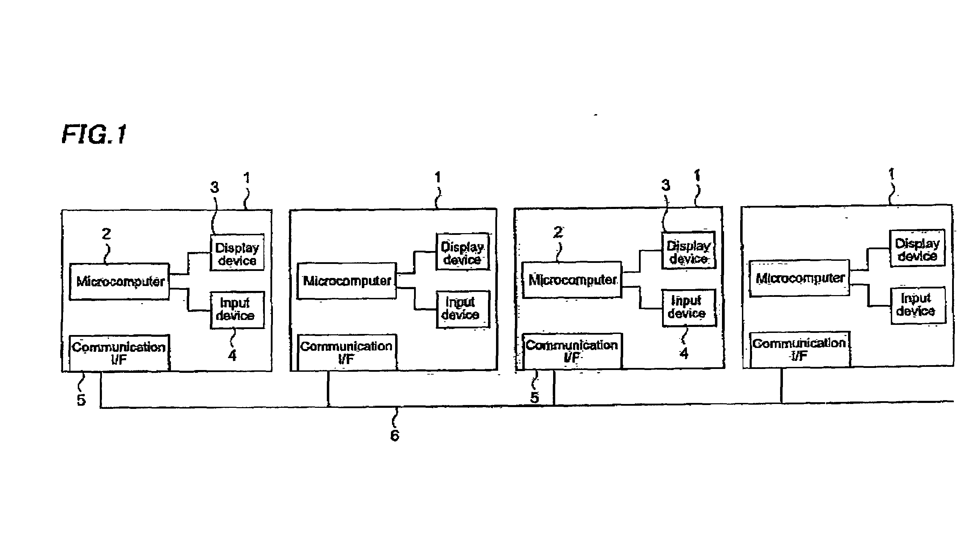

First, a structure of a management system of a printed circuit board production line will be described referring to Fig. 1. This production line is a board assembling line for assembling a printed circuit board in a factory. Each of work apparatuses forming this board assembling line includes a screen printing apparatus that coats solder paste on a printed board, an adhesive coating apparatus that coats an adhesive on a printed board, an electronic component mounting apparatus that mounts an electronic component picked up from a component feeding unit by a suction nozzle mounted on a mounting head and mounts the electronic component on a printed board, and so on. For simplicity, however, the following description will use only four electronic component mounting apparatuses 1 as the work apparatuses of which the start controls of the mounting operations are manageable in the board assembling line.

However, the invention is not limited to these electronic component mounting apparatuses 1. The invention is also applicable to the start of a printing operation of other screen printing apparatus and the start of a coating operation of other adhesive coating apparatus, and further applicable to all the work apparatuses that form a board assembling line.

Multiple component feeding units in each of the electronic component mounting apparatuses 1 are detachably arrayed on the feeder bases of a cart as a fixation mount, and the cart is detachably set on the body of the electronic component mounting apparatus 1. The component feeding units are set thereon so that the end portions on their component feeding sides are positioned in a mounting head pickup region. The component feeding unit has a tape forwarding system that intermittently forwards a storage tape to an electronic component pickup position by a forwarding motor by turning a forwarding sprocket by a given angle, the teeth of the forwarding sprocket being engaged with forwarding holes formed at given intervals in the storage tape sequentially forwarded from a feed reel on which the storage tape is wound, the feed reel being rotatably set on the cart. The component feeding unit also has a cover tape peeling system that peels a cover tape from a carrier tape that is part of the storage tape in a position before the component pickup position by a peeling motor. The cover tape is peeled by the cover tape peeling system, and electronic components stored in storage portions formed in the carrier tape at given intervals are sequentially fed to the component pickup position and picked up from the end portion by suction nozzles as pickup means.

Each of the electronic component mounting apparatuses 1 has a control microcomputer 2 controlling operations relating to the component mounting operation for mounting electronic components on a printed board, and this microcomputer 2 is connected to a display device 3 such as a monitor through a LAN 6 and an input device 4 including touch panel switches displayed on the monitor, for example. Each of the microcomputers 2 is connected to a communication interface 5, and data such as various types of commands are transmittable and receivable between the microcomputers 2 through the communication interfaces 5 and the LAN 6.

The microcomputer 2 includes a CPU (central processing unit) as control means, a ROM (read only memory) storing programs, and a RAM (random access memory) as memory means, The CPU controls operations relating to the component mounting operation based on data stored in the RAM and according to programs stored in the ROM.

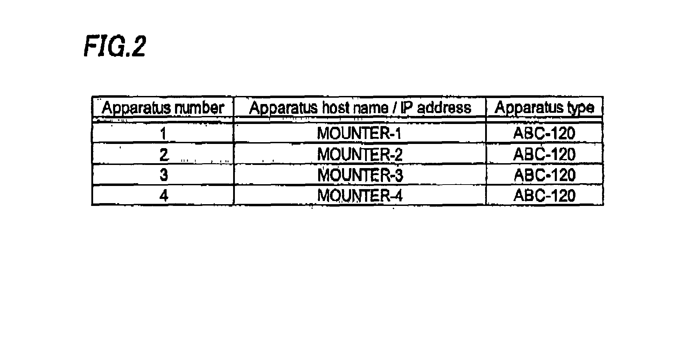

Mounting data indicating the mounting coordinates of electronic components on a printed board in mounting order, component library data indicating the features of electronic components, line registered apparatus list data and so on are stored in the RAM. The line registered apparatus list data includes the apparatus numbers of the electronic component mounting apparatuses 1, the apparatus host names (IP addresses) and the apparatus types (machine types) as shown in Fig. 2.

Furthermore, the structures of the apparatuses of which the start controls of the mounting operations are manageable in the board assembling line are stored in the RAM in disposition order in the board assembling line.

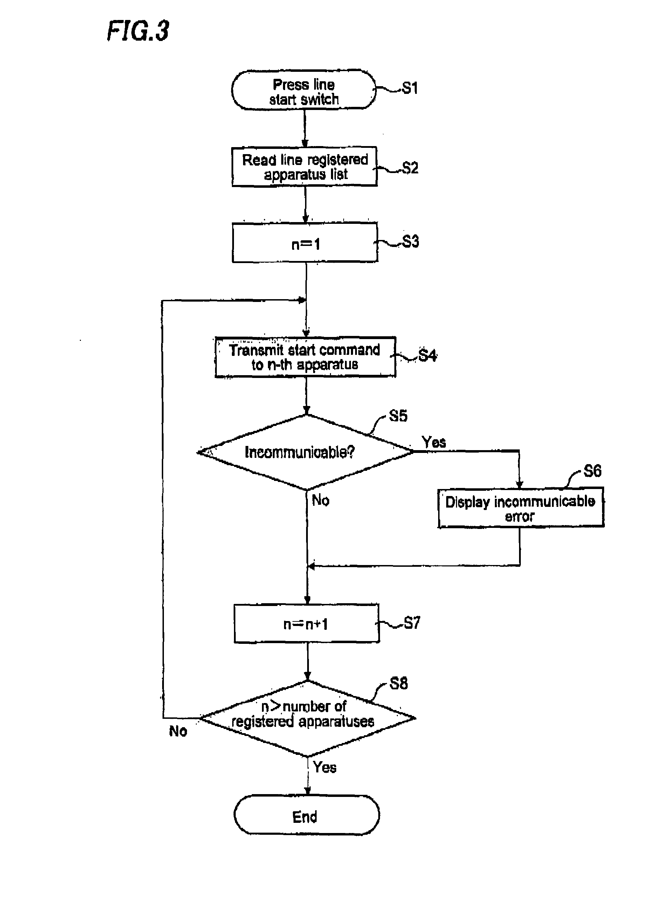

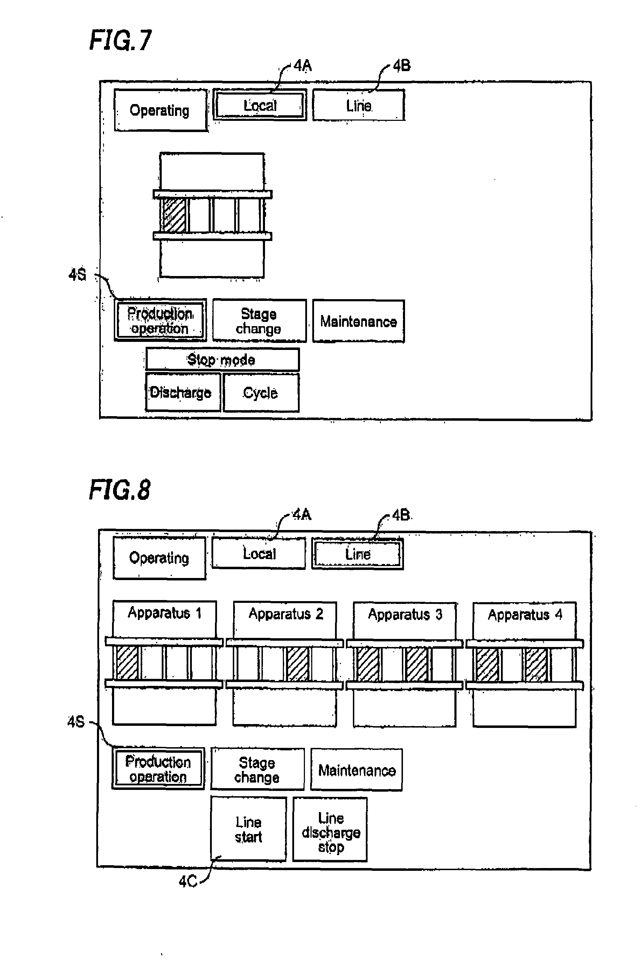

With the structures described above, the electronic component mounting operation will be described briefly. First, referring to a flowchart of Fig. 3 for the electronic component mounting apparatus 1 on a command transmitter side, a manager presses a line start switch 4C (Fig. 8) of the input device 4 of one of the four electronic component mounting apparatuses 1 in the board assembling line, that is the third from the left (from the upstream side) and positioned near the manager, for example, so as to start the mounting operations of the manageable apparatuses in the board assembling line (step S1). Then the microcomputer 2 of this electronic component mounting apparatus 1 reads the line registered apparatus list data of Fig. 2 stored in its own RAM (step 32).

In detail, on the screen of the display device 3 of the third electronic component mounting apparatus 1 from the left, a "production operation" is selected by pressing a production operation start switch 4S (Figs. 7, 8) and a "local" is selected by pressing a local switch 4A. When the manager presses a line switch 4B, the screen changes from the state of Fig. 7 to the state of Fig. 8. Then when the manager presses the line start switch 4C in this state (step S1), the microcomputer 2 of this electronic component mounting apparatus 1 reads the line registered apparatus list data stored in its own RAM (step S2).

It is noted that the local switch 4A is to select a single operation of one of the electronic component mounting apparatuses 1, and the line switch 4B is to select the operations of all the manageable apparatuses in the board assembling line.

Then the microcomputer 2 of the third electronic component mounting apparatus 1 from the left counts n = 1 (step S3) and transmits a start command to the n-th electronic component mounting apparatus 1 from the left (step S4). In detail, the microcomputer 2 of the third electronic component mounting apparatus 1 from the left transmits the start command to the first electronic component mounting apparatus 1, i.e., the leftmost electronic component mounting apparatus 1 (to the microcomputer 2 thereof).

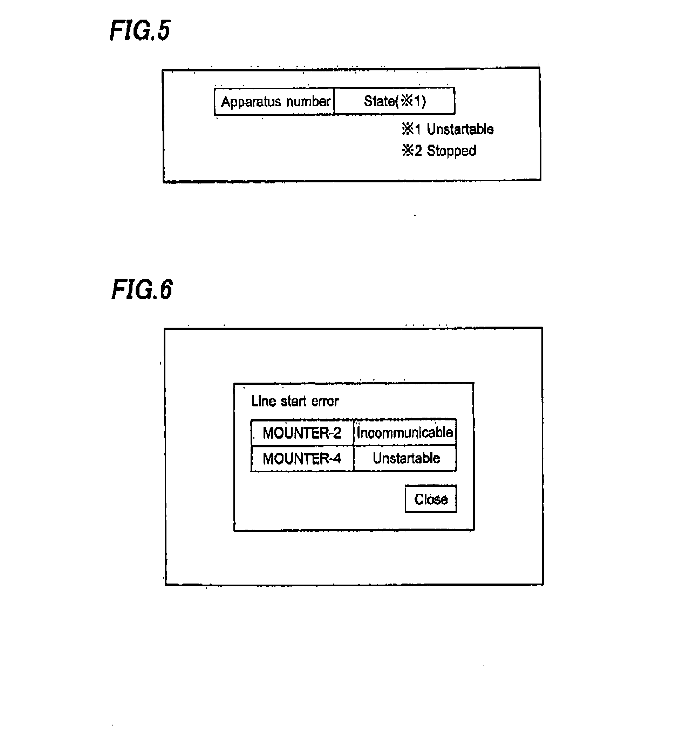

After this start command is transmitted, the microcomputer 2 of the third electronic component mounting apparatus 1 from the left judges whether or not it can communicate with the microcomputer 2 of the leftmost electronic component mounting apparatus 1 (step S5). At this time, the microcomputer 2 of the third electronic component mounting apparatus 1 judges the leftmost electronic component mounting apparatus as incommunicable when the power supply of the leftmost electronic component mounting apparatus 1 is turned off or when there is a trouble in the communication path between the microcomputer 2 of the third electronic component mounting apparatus 1 and the microcomputer 2 of the leftmost electronic component mounting apparatus 1, and displays the incommunicable state as an error on its own display device 3 as shown in a line start error screen of Fig. 6 (step 56). It is noted that Fig. 6 shows an example of displaying the incommunicable state of the second electronic component mounting apparatus 1 from the left as an error.

After the microcomputer 2 of the third electronic component mounting apparatus 1 from the left judges the first electronic component mounting apparatus 1 as communicable in the step S5, or after the microcomputer 2 of the third electronic component mounting apparatus 1 from the left judges the first electronic component mounting apparatus 1 as incommunicable and displays the incommunicable state as an error on the display device 3 in the step S6, the microcomputer 2 of the third electronic component mounting apparatus 1 adds "1" to n = 1 (step S7), and judges whether or not this calculated number (1 + 1 = "2") is larger than "4" that is the number of registered apparatuses (step S8). The microcomputer 2 of the third electronic component mounting apparatus 1 from the left judges the calculated number as not larger than "4" that is the number of registered apparatuses, and then the microcomputer 2 transmits a start command to the second electronic component mounting apparatus 1 from the left (step S4).

After this start command is transmitted, the microcomputer 2 of the third electronic component mounting apparatus 1 from the left judges whether or not it can communicate with the second electronic component mounting apparatus 1 from the left (step S5). At this time, the microcomputer 2 of the third electronic component mounting apparatus 1 from the left judges the second electronic component mounting apparatus from the left as incommunicable when the power supply of the second electronic component mounting apparatus 1 from the left is turned off or when there is a trouble in the communication path between the microcomputer 2 of the third electronic component mounting apparatus 1 from the left and the microcomputer 2 of the second electronic component mounting apparatus 1 from the left, and displays the incommunicable state as an error on its own display device 3 (step S6).

After the microcomputer 2 of the third electronic compcnent mounting apparatus 1 from the left judges the second electronic component mounting apparatus 1 as communicable in the step S5, or after the microcomputer 2 of the third electronic component mounting apparatus 1 from the left judges the second electronic component mounting apparatus 1 as incommunicable and displays the incommunicable state as an error on the display device 3 in the step S6, the microcomputer 2 of the third electronic component mounting apparatus 1 adds "1" to n = 2 (step S7), and judges whether or not this calculated number (2 + 1 = "3") is larger than "4" that is the number of registered apparatuses (step S8). The microcomputer 2 of the third electronic component mounting apparatus 1 from the left judges the calculated number as not larger than "4" that is the number of registered apparatuses, and then the third electronic component mounting apparatus 1 from the left transmits a start command to itself (step S4).

Then the microcomputer 2 of the third electronic component mounting apparatus 1 from the left judges itself as communicable (step S5), or the microcomputer 2 of the third electronic component mounting apparatus 1 from the left judges itself as incommunicable and displays the incommunicable state as an error on the display device 3 in the step S6. The microcomputer 2 of the third electronic component mounting apparatus 1 then adds "1" to n = 3 (step S7), and judges whether or not this calculated number (3 + 1 = "4") is larger than "4" that is the number of registered apparatuses (step S8). The microcomputer 2 of the third electronic component mounting apparatus 1 from the left judges the calculated number as not larger than "4" that is the number of registered apparatuses, and then the microcomputer 2 transmits a start command to the fourth electronic component mounting apparatus 1 from the left (step S4).

Then the microcomputer 2 of the third electronic component mounting apparatus 1 from the left judges the fourth electronic component mounting apparatus 1 as communicable in the step S5, or the microcomputer 2 of the third electronic component mounting apparatus 1 from the left judges the fourth electronic component mounting apparatus 1 as incommunicable and displays the incommunicable state as an error on the display device 3 in the step S6. The microcomputer 2 of the third electronic component mounting apparatus 1 from the left then adds "1" to n = 4 (step S7), and judges whether or not this calculated number

(4 + 1 = "5") is larger than "4" that is the number of registered apparatuses (step S8). At this time, 4 + 1 is judged as larger than "4" as the number of registered apparatuses, and thus the flowchart of the third electronic component mounting apparatus 1 from the left on the transmitter side ends.

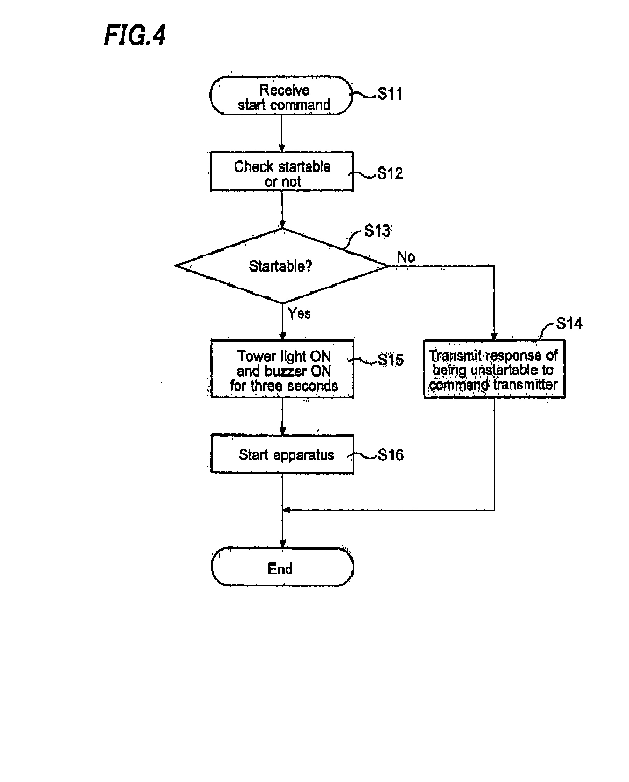

On the other hand, a flowchart of Fig. 4 for the electronic component mounting apparatus 1 on a command receiver side will be described next. As described above, when the other electronic component mounting apparatuses 1 than the third electronic component mounting apparatus 1 from the left receive the start command from the microcomputer 2 of the third electronic component mounting apparatus 1 from the left (step S11), the microcomputer 2 of each of the electronic component mounting apparatuses 1 that receive the start command checks whether or not it can start the mounting operation (whether or not it is startable) (step S12).

In detail, the microcomputer 2 of each of the electronic component mounting apparatuses 1 that receive the start command judges that it can not start the mounting operation when the disposition of the component feeding units on the feeder bases is different from the disposition data, the disposition of the suction nozzles mounted on the mounting head is different from the disposition data, or there is a mistake in the mounting data, for example.

By this check, the microcomputer 2 of each of the electronic component mounting apparatuses 1 that receive the start command judges whether or not it can start the mounting operation (step S13). When the microcomputer 2 judges itself as unstartable, it transmits a response of being unstartable for the mounting operation to the third electronic component mounting apparatus 1 from the left that transmits the start command (step S14). This response of being unstartable includes the apparatus number and state of the electronic component mounting apparatus 1 as shown in the Fig. 5. 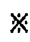 1 means an unstartable state in which the electronic component mounting apparatus 1 can not start the mounting operation, and 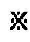 2 means a stop state in which the electronic component mounting apparatus 1 is being stopped.

After this electronic component mounting apparatus 1 that receives the start command transmits a response of being unstartable for the mounting operation to the third electronic component mounting apparatus 1 from the left that transmits the start command, as shown in a line start error screen of Fig. 6, this third electronic component mounting apparatus 1 displays the mounting operation unstartable state of the electronic component mounting apparatus (e.g. the fourth from the left) that transmits the response of being unstartable on its own display device 3.

By this check, when the microcomputer 2 of the electronic component mounting apparatus 1 that receives the start command judges itself as startable (step S13), this microcomputer 2 turns on the tower light of the electronic component mounting apparatus 1 that receives the start command and turns on and sounds the buzzer thereof for three seconds. By this, the electronic component mounting apparatus 1 that receives the start command informs the manager that it is to start the mounting operation, and the manager recognizes it (step S15).

After the informing, the electronic component mounting apparatus 1 that receives the start command starts the mounting operation or make a printed board ready. Starting the mounting operation means to start the mounting operation such as bringing a printed board to the positioning portion, picking up an electronic component from the component feeding unit, mounting an electronic component on a printed board that reaches the positioning portion, and so on. Making a printed board ready means to make the mounting operation ready for starting whenever a printed board reaches the positioning portion. When a printed board reaches the positioning portion in the electronic component mounting apparatus 1, the mounting operation starts. In detail, electronic components are mounted on the printed board according to the mounting data (not shown), and when the electronic components are completed to be mounted on the printed board, the printed board is discharged, and the next printed board is brought to the positioning portion, electronic components are mounted thereon as described above, and the mounting operation is thus continued.

As described above, even when there is a plurality of electronic component mounting apparatuses as work apparatuses in a board assembling line, the invention decreases manager's work by enabling the manager to operate any one of the work apparatuses so as to start the mounting operations of the other work apparatuses.

The work in the electronic component mounting apparatus 1 is not limited to the mounting operation, and includes a stage change operation for changing the width of a carrying path for printed boards and so on corresponding to the size of printed circuit boards to be product next when printed circuit boards to be product are changed, for example. When there is a plurality of electronic component mounting apparatuses 1 as work apparatuses in a board assembling line, manager's work is decreased by enabling the manager to operate any one of work apparatuses to start the stage changing operations and so on of the other work apparatuses.

Although the line start error screen of Fig. 6 is displayed on the display device 3 of the third electronic component mounting apparatus 1 from the left, the invention is not limited to this. The content of this line start error screen may be transmitted to all the electronic component mounting apparatuses 1 and so on in the board assembling line or specified one of the electronic component mounting apparatuses 1 and so on and displayed on the display devices thereof.

As described above, when the mounting operation of electronic components on a printed board is started in each of the electronic component mounting apparatuses 1 forming the board assembling line, a printed board is first brought from an upstream apparatus (not shown) to the board supply portion of the carrying device, and the printed board on this board supply portion is moved to the board positioning portion and fixedly positioned. After the printed board is positioned, the beam mounted on the electronic component mounting apparatus 1 is moved in the Y direction by the Y direction linear motor, and simultaneously the mounting head mounted on the beam is moved in the X direction by the X direction linear motor, reaching a position above the component pickup position of the corresponding component feeding unit. Then the suction nozzles mounted on the mounting head are descended by the vertical axis motor to pick up electronic components from the component feeding units.

After picking up the electronic components, the suction nozzles of the mounting head are ascended, and the mounting head of the beam passes above the component recognition camera. During this movement, the camera takes images of the plurality of electronic components held by the plurality of suction nozzles sequentially, and the recognition processing device performs a recognition process to these images and recognizes the positional shifts of the electronic components relative to the suction nozzles.

The mounting heads have board recognition cameras respectively, and the board recognition camera is moved to above the printed board and takes an image of a positioning mark given to the printed board. The recognition processing device performs a recognition process to the image to recognize the position of the printed board.

Then the result of the recognition process of the positioning mark of the printed board and the result of the component recognition process are added to the mounting coordinates in the mounting data, and the suction nozzles correct the positional shifts and mount the electronic components on the printed board. After all the electronic components are thus mounted on the printed board, this printed board is moved from the board positioning portion to a downstream apparatus through the board discharge portion, thereby completing the mounting operation of the electronic components on this printed board.

A second embodiment of the invention will be described hereafter.

First, a structure of a management system of a printed circuit board production line will be described referring to Fig. 1. This production line is a board assembling line for assembling a printed circuit board in a factory. Each of work apparatuses forging this board assembling line includes a screen printing apparatus that coats solder paste on a printed board, an adhesive coating apparatus that coats an adhesive on a printed board, an electronic component mounting apparatus that mounts an electronic component picked up from a component feeding unit by a suction nozzle mounted on a mounting head and mounts the electronic component on a printed board, and so on. For simplicity, however, the following description will use only four electronic component mounting apparatuses 1 as work apparatuses of which the discharge controls of printed boards are manageable in the board assembling line. However, the invention is not limited to these electronic component mounting apparatuses 1. The invention is also applicable to the discharges of printed boards of all the work apparatuses that form a board assembling line such as other screen printing apparatus or adhesive coating apparatus. In this case, four electronic component mounting apparatuses 1 in Fig. 1 are disposed from the upstream side toward the downstream side. The electronic component mounting apparatuses 1 on the left side is on the more upstream side than the electronic component mounting apparatuses 1 on the right side, and printed boards are sequentially discharged from the upstream electronic component mounting apparatus 1 to the next downstream electronic component mounting apparatus 1.

The structures of the component feeding unit and the electronic component mounting apparatuses 1 are the same as those in the first embodiment described above, and the description of the details will be omitted.

The microcomputer 2 includes a CPU (central processing unit) as control means, a ROM (read only memory) storing programs, and a RAM (random access memory) as memory means. The CPU controls operations relating to the component mounting operation based on data stored in the RAM and according to programs stored in the ROM.

Mounting data indicating the mounting coordinates of electronic components on a printed board in mounting order, and component library data indicating the features of electronic components are stored in the RAM. Furthermore, the structures of the apparatuses of which the printed board discharge controls are manageable in the board assembling line are stored in the RAM in disposition order in the board assembling line.

When the mounting operation of electronic components on a printed board is started in the electronic component mounting apparatuses 1 forming the board assembling line, electronic components are mounted on a printed board in the same manner as the first embodiment, After all the electronic components are thus mounted on the printed board, this printed board is moved from the board positioning portion to a downstream apparatus through the board discharge portion, thereby completing the mounting operation of the electronic components on this printed board.

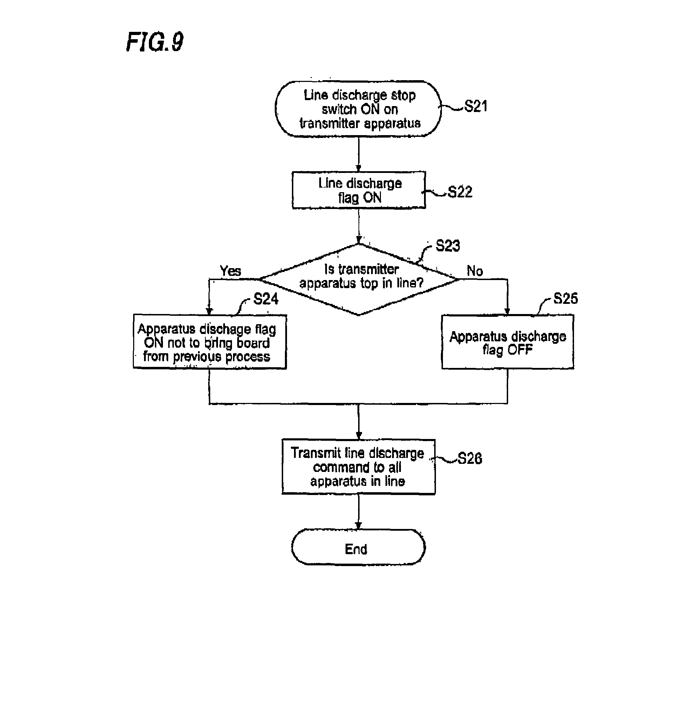

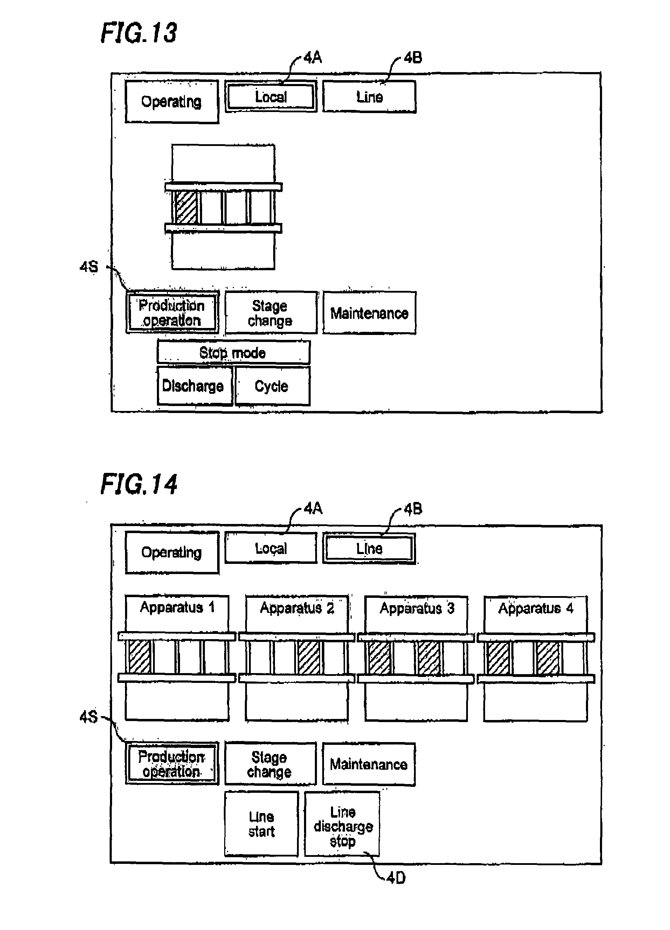

Next, the printed board discharge operation will be described. First, referring to a flowchart of Fig. 9 for the electronic component mounting apparatus 1 on a command transmitter side, when there are four manageable apparatuses (there is also a unmanageable apparatus.), so as to stop the printed board discharging and mounting operations in each of the apparatuses forming the board assembling line, a manager operates a line discharge stop switch 4D (Fig. 14) on the input device 4 of one of these electronic component mounting apparatuses 1 in the board assembling line, that is the third from the left (from the upstream side) and positioned near the manager (step 521).

In detail, on the screen of the display device 3 of the third electronic component mounting apparatus 1 from the left, a "production operation" is selected by pressing a production operation start switch 4S and a "local" is selected by pressing the local switch 4A. When the manager presses a line switch 4B, the screen changes from the state of Fig. 13 to the state of Fig. 14. Then the manager presses the line discharge stop switch 4D in this state (step S21).

It is noted that the local switch 4A is to select a single operation of one of the electronic component mounting apparatuses 1, and the line switch 4B is to select the operations of all the manageable apparatuses in the board assembling line.

Then the microcomputer 2 of this third electronic component mounting apparatus 1 from the left turns on a line discharge flag for discharging a printed board from the third electronic component mounting apparatus 1 to the downstream apparatus, and stores it in its own RAM (step S22).

Then the microcomputer 2 of the third electronic component mounting apparatus 1 from the left judges whether or not the third electronic component mounting apparatus 1 itself is the top one among the manageable apparatuses (there is also an unmanageable apparatus.) in the board assembling line (step S23). In this case, the top apparatus means the most upstream apparatus, i.e., the first electronic component mounting apparatus from the left in the example of Fig. 1. When the microcomputer 2 of the third electronic component mounting apparatus 1 judges itself as the top apparatus, the microcomputer 2 controls itself to turn on the apparatus discharge flag and store it, to discharge a printed board in the third electronic component mounting apparatus 1 to the downstream apparatus, and not to bring in a printed board from the previous process, i.e., from the more upstream apparatus adjacent to the top apparatus (step S24). In actual, however, the third electronic component mounting apparatus 1 is not the top apparatus but the third from the left. Therefore, when the apparatus discharge flag is in the on state, it is turned off (meaning erase), or when the apparatus discharge flag is in the off state, it is kept as it is (step S25).

Regardless of whether or not the third electronic component mounting apparatus 1 judges itself as the top one, the microcomputer 2 of this third electronic component mounting apparatus 1 from the left then transmits a line discharge command to all the manageable apparatuses in the board assembling line so as to command all the manageable apparatuses to discharge a printed board (step S26), and ends.

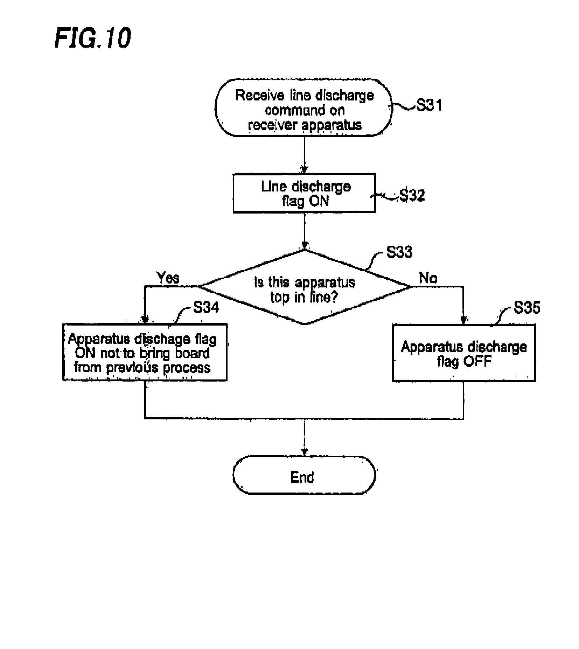

Referring to a flowchart of Fig. 10 for the electronic component mounting apparatus 1 on a receiver side, when each of the manageable apparatuses receives the line discharge command from the third electronic component mounting apparatus 1 from the left (step S31), each of the manageable apparatuses turns on the line discharge flag and stored it in its own RAM (step S32).

Then the microcomputer 2 of each of the electronic component mounting apparatuses 1 that receives the line discharge command judges whether or not itself is the top one among the manageable apparatuses (there is also an unmanageable apparatus) in the board assembling line (step S33). When the microcomputer 2 of the electronic component mounting apparatus 1 judges itself as the top apparatus, the microcomputer 2 controls itself to turn on the apparatus discharge flag, to discharge the last printed board of a type under production to the downstream apparatus, and not to bring in a printed board from the previous process, i.e., from the more upstream apparatus adjacent to the top apparatus (not to transmit a board request signal) (step S34). When the microcomputer 2 of the electronic component mounting apparatus 1 judges itself as not the top apparatus, it turns off the apparatus discharge flag when it is in the on state, or keeps the off state when it is in the off state (step S35), and ends.

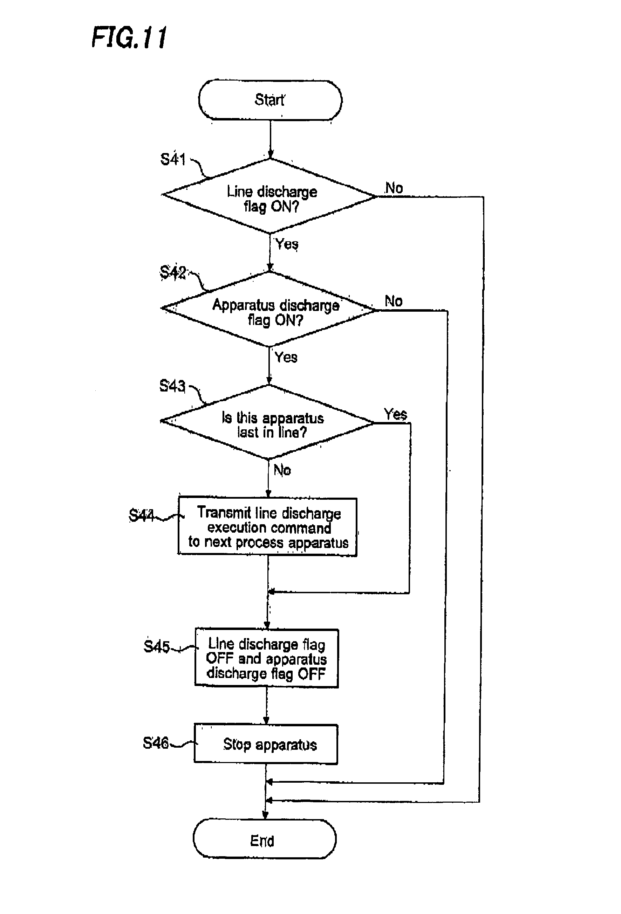

Referring to Fig. 11 showing a flowchart of a process of discharging a last printed board of a type under production in each of the manageable electronic component mounting apparatuses 1, the microcomputer 2 of each of the electronic component mounting apparatuses 1 first judges whether or not its own RAM stores an on-state line discharge flag (step S41).

When the microcomputer 2 judges that the RAM does not store the on-state line discharge flag, the microcomputer 2 ends. When the microcomputer 2 judges that the RAM stores the on-state line discharge flag, the microcomputer 2 judges whether or not the RAM stores an on-state apparatus discharge flag (step S42).

In this case, referring to the flowcharts in Figs. 9 and 10 described above, the other electronic component mounting apparatuses 1 than the top electronic component mounting apparatus 1 have the off-state apparatus discharge flag and end, but the top electronic component mounting apparatus 1 has the on-state apparatus discharge flag. Therefore, the top electronic component mounting apparatus 1 discharges the last printed board of a type under production to the second electronic component mounting apparatus 1 from the top (the second one from the left), and judges whether or not the top electronic component mounting apparatus 1 itself is the last one among the manageable apparatuses in the board assembling line (step S43). In this case, the last apparatus means the most downstream apparatus, i.e., the fourth electronic component mounting apparatus 1 from the top in the example of Fig. 1.

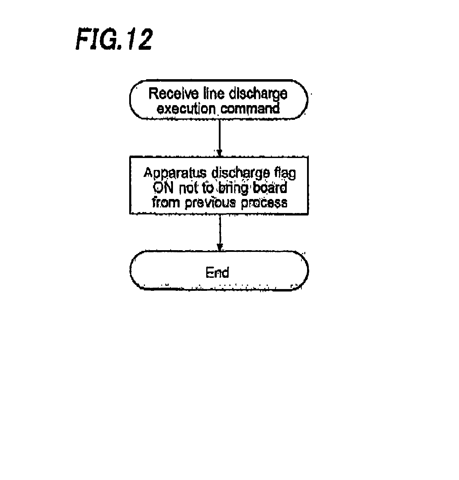

When the top electronic component mounting apparatus 1 judges itself as the last apparatus, it turns off the line discharge flag and the apparatus discharge flag (step S45), stops the mounting operation (step S46), and ends. However, in this case, since the top electronic component mounting apparatus 1 is not the last apparatus, the top electronic component mounting apparatus 1 transmits a line discharge execution command to the second electronic component mounting apparatus 1 as the next process apparatus so as to command the second electronic component mounting apparatus 1 to discharge the last printed board to the downstream third electronic component mounting apparatus 1 (step S44). Therefore, as shown in Fig. 12, the second electronic component mounting apparatus 1 as the next process that receives this line discharge execution command turns on the apparatus discharge flag and stores it in its own RAM, and controls itself so as not to bring in other printed board than the last printed board of the type under production from the previous process.

After the top electronic component mounting apparatus 1 transmits the line discharge execution command to the second electronic component mounting apparatus 1 as the next process apparatus (step S44), the top electronic component mounting apparatus 1 turns off the line discharge flag and the apparatus discharge flag (step S45), stops the mounting operation (stops mounting, hereafter referred to similarly) (step S46), and ends.

Then, as shown in Fig. 11, since the second electronic component mounting apparatus 1 from the top, of which the apparatus discharge flag is thus turned on, has the on-state line discharge flag (step S41) and the on-state apparatus discharge flag, it discharges the last printed board of the type under production to the third electronic component mounting apparatus 1 from the top (step S42). Since the second electronic component mounting apparatus 1 itself is not the last apparatus (step S43), it transmits a line discharge execution command to the third electronic component mounting apparatus 1 as the next process apparatus so as to command the third electronic component mounting apparatus 1 to discharge the last printed board to the downstream fourth electronic component mounting apparatus 1 (step 544). Therefore, as shown in Fig. 12, the third electronic component mounting apparatus 1 as the next process that receives this line discharge execution command turns on the apparatus discharge flag and stores it in its own RAM, and controls itself so as not to bring in other printed board than the last printed board of the type under production from the previous process.

After the second electronic component mounting apparatus 1 from the top transmits the line discharge execution command to the third electronic component mounting apparatus 1 from the Lop as the next process apparatus (step S44), the second electronic component mounting apparatus 1 from the top turns off the line discharge flag and the apparatus discharge flag (step S45), stops the mounting operation (step S46), and ends.

Then, as shown in Fig. 11, since the third electronic component mounting apparatus 1 from the top, of which the apparatus discharge flag is thus turned on, has the on-state line discharge flag (step S41) and the on-state apparatus discharge flag, it discharges the last printed board of the type under production to the fourth electronic component mounting apparatus 1 from the top (step S42). Since the third electronic component mounting apparatus 1 itself is not the last apparatus (step S43), it transmits a line discharge execution command to the fourth electronic component mounting apparatus 1 as the next process apparatus so as to command the fourth electronic component mounting apparatus 1 to discharge the last printed board to the downstream apparatus (step S44). Therefore, as shown in Fig. 13, the fourth electronic component mounting apparatus 1 as the next process that receives this line discharge execution command turns on the apparatus discharge flag and stores it in its own RAM, and controls itself so as not to bring in other printed board than the last printed board of the type under production from the previous process.

After the third electronic component mounting apparatus 1 from the top transmits the line discharge execution command to the fourth electronic component mounting apparatus 1 from the top as the next process apparatus (step S44), the third electronic component mounting apparatus 1 from the top turns off the line discharge flag and the apparatus discharge flag (step S43), stops the mounting operation (step S46), and ends.

Then, as shown in Fig. 11, since the fourth electronic component mounting apparatus 1 from the top, of which the apparatus discharge flag is thus turned on, has the on-state line discharge flag (step S41) and the on-state apparatus discharge flag, it discharges the last printed board of the type under production to a downstream fifth apparatus from the top (step S42). Since the fourth electronic component mounting apparatus 1 itself is the last apparatus (step S43), the fourth electronic component mounting apparatus 1 turns off the line discharge flag and the apparatus discharge flag (step S45), stops the mounting operation (step S46), and ends.

As described above, even when there is a plurality of electronic component mounting apparatuses 1 as work apparatuses in a board assembling line, the invention decreases manager's work by enabling the manager to operate any one of the work apparatuses so as to perform the printed board discharge operations of the other work apparatuses. Furthermore, as described above, the invention is not limited to the discharging of a printed board in the electronic component mounting apparatus 1 only, and is also applicable to the discharging of a printed board in all the work apparatuses forming a board assembling line such as other screen printing apparatus, adhesive coating apparatus and so on.

The embodiments of the invention are described above. It is recognized that variations or modifications of the disclosed method are possible based on the disclosure for those skilled in the art and lie within the scope of the invention.

Even when there is a plurality of work apparatuses in a board assembling line, the invention decreases manager's work by enabling the manager to operate any one of the work apparatuses so as to start the works of the other work apparatuses.

Furthermore, even when there is a plurality of work apparatuses in a board assembling line, the invention decreases manager's work by enabling the manager to operate any one of the work apparatuses so as to start the mounting operations of the other work apparatuses.

Furthermore, even when there is a plurality of work apparatuses in a board assembling line, the invention decreases manager's work by enabling the manager to operate any one of the work apparatuses so as to perform the printed board discharge operations of the other work apparatuses.

## Claims

1. A method of managing a board assembling line comprising a plurality of work apparatuses (1), wherein a printed circuit board is assembled by mounting electronic components thereon using the work apparatuses (1), the method comprising:
transmitting a work start command to start work from any one of the plurality of work apparatuses (1) to the other work apparatus (1).

2. The method of claim 1, further comprising transmitting a response of being unstartable for the work from the other work apparatus (1) that receives the work start command to the work apparatus(1) that transmits the work start command when the other work apparatus can not start the work.

3. The method of claim 1, further comprising displaying the response of being unstartable for the work on a display device of the work apparatus (1) that receives the response.

4. The method of any one of claims 1 to 3, wherein the work comprises mounting the electronic components on the printed board.

5. The method of any one of claims 1 to 3, wherein the work comprises performing screen-printing to the printed board.

6. The method according to any of claims 1 to 5, wherein the work comprises discharging the printed board from an upstream work apparatus to a downstream work apparatus among the plurality of work apparatuses.

7. The method according to any of claims 1 to 5, wherein the work comprises discharging the printed board from an upstream work apparatus to a downstream work apparatus among the plurality of work apparatuses, the upstream work apparatus that receives the work start command discharging the printed board to the downstream work apparatus.

8. The method of claim 7, further comprising transmitting a line discharge command from any one of the work apparatuses tc the other work apparatus so as to command the other work apparatus to stop the mounting operation after the other work apparatus discharges a last printed board of a type under production, the work apparatus that receives this line discharge command discharging the printed board to a downstream work apparatus and stopping the mounting operation.

9. The method of claim 8, further comprising, storing a line discharge flag in the work apparatus that receives the line discharge command;
storing an apparatus discharges flag, discharging the last printed board of the type under production to the downstream work apparatus, and stopping the mounting operation when the work apparatus that receives the line discharge command is a top one among the plurality of work apparatuses;
transmitting a line discharge execution command from each of the work apparatuses to a downstream work apparatus so as to command the downstream work apparatus to discharge the last printed board when the work apparatus stores the line discharge flag and the apparatus discharge flag and is not a last work apparatus in the line; and
erasing the line discharge flag and the apparatus discharge flag after the transmitting.

10. Managing-system for a board assembling line comprising a plurality of work apparatuses (1), which are configured to assemble a printed circuit board by mounting electronic components thereon, **characterized in that**
the work apparatuses (1) are connected by a network (6) and configured such that a work start command from any of the plurality of work apparatuses (1) is transmitted to the other work apparatus (1).

11. Managing-system according to claim 10, **characterized in that** the working apparatuses (1) comprise a microcomputer (2) and an interface (3) for connection to the network (6) such that commands are transmittable and receivable between the microcomputers (2).

12. Managing-system according to claim 11, **characterized in that** the microcomputer (2) includes a CPU and a memory, the memory comprising a data list on registered work apparatuses (1).

13. Managing-system according to claim 12, **characterized in that** a data list is configured to comprise apparatus numbers of the working apparatuses (1), their host names and types of the working apparatuses (1).

14. Managing-system according to any of claims 10 - 13, **characterized in that** at least one of the working apparatuses (1) is provided with a line start switch (4C), and wherein the other working apparatus (1) judges whether it can start and if unstartable transmits a response of being unstartable to said working apparatus (1) with the line start switch (4C).

15. Managing-system according to any of claims 10 - 14, **characterized in that** it is configured such as to execute the method of any of claims 2 - 9.
